# EUROPEAN PATENT SPECIFICATION

(11) **EP 4 486 078 B1**
(45) Date of publication and mention of the grant of the patent: **25.02.2026**
(21) Application number: 23182069.7
(22) Date of filing: 28.06.2023
(51) Int. Cl.: H05K 3/30

(54) **METHOD FOR MOUNTING A POWER SEMICONDUCTOR DEVICE TO A PRINTED CIRCUIT BOARD USING AN ALIGNMENT DEVICE**
VERFAHREN ZUR MONTAGE EINES LEISTUNGSHALBLEITERBAUELEMENTS AUF EINER LEITERPLATTE UNTER VERWENDUNG EINER AUSRICHTUNGSVORRICHTUNG
PROCÉDÉ DE MONTAGE D'UN DISPOSITIF SEMI-CONDUCTEUR DE PUISSANCE SUR UNE CARTE DE CIRCUIT IMPRIMÉ À L'AIDE D'UN DISPOSITIF D'ALIGNEMENT

(43) Date of publication of application: 01.01.2025
(73) Proprietor: Hitachi Energy Ltd, 8050 Zürich (CH)
(72) Inventor: TRUESSEL, Dominik, 5620 Bremgarten (CH); FISCHER, Fabian, 5400 Baden (CH); KELLER, Tobias, 5412 Gebenstorf (CH)
(74) Representative: Epping - Hermann - Fischer

(56) References cited:
- DE-U1- 202021 100 914

## Description

The present disclosure relates to an arrangement comprising a power semiconductor device and an alignment device wherein the alignment device is mounted to the semiconductor device, and a method using the alignment device for mounting the power semiconductor device to a printed circuit board.

When implementing power semiconductor modules in an application, the power semiconductor modules must be interconnected with control electronics like gate drivers or other integrated circuits for control. These control devices are typically arranged on an assembly board, such as on a control board e.g. realized by a printed circuit board. Such an assembly board can be arranged on top of the power semiconductor modules. The electrical connections between the power semiconductor modules and the assembly board are typically provided by terminals, like auxiliary terminals/control terminals or power terminals of the power module. There is a need for exactly placing the power modules relative to the position of the assembly board for facilitating the process of mechanically and electrically interconnecting the power modules to the assembly board.

DE 20 2021 100 914 U1 discloses a device for mounting a electronic power component on a printed circuit board, comprising a main body with a first part adapted to be associated with the printed circuit board and a second part with a first receiving seat for the electronic component, pushing means cooperating with the first seat to exert a pressure on the electronic component and to couple a heat exchange surface of the electronic component to heat dissipation means, wherein the first part and the second part of the main body form a single piece made of electrically insulating material, the first part comprising first mechanical connection means to the circuit board.

It is an object to mount a power semiconductor device in a simple manner to a printed circuit board (PCB) while still enable proper alignment of the power semiconductor device to the printed circuit board (PCB).

This object is solved by the features of the independent claims. Advantageous embodiments are indicated in the dependent claims.

Embodiments of the disclosure, for instance as claimed in the independent claims, address the above shortcomings in the art in whole or in part. Further embodiments of the power semiconductor device, the alignment device and of the method for interconnecting the power semiconductor device to an assembly board, for instance to a printed circuit board (PCB), are subject matter of the further claims.

There is provided, a method for mounting a power semiconductor device to a printed circuit board (PCB) comprising the steps of providing the power semiconductor device and an alignment device. The method further comprises the step of inserting at least one terminal of the power semiconductor device into at least one first alignment structure of the alignment device, concurrent with mounting the alignment device to the power semiconductor device. Furthermore the printed circuit board (PCB) is provided and the printed circuit board (PCB) is aligned to the alignment device, concurrent with inserting at least partially a first portion of the at least one terminal into at least one contact hole of the printed circuit board (PCB). After inserting at least partially the first portion of the at least one terminal, the first portion of the at least one terminal of the power semiconductor device is fixed to the printed circuit board (PCB).

The mounting of the alignment device to the power semiconductor device causes the at least one terminal of the power semiconductor device to be properly aligned and well supported with respect to the printed circuit board (PCB). Furthermore the alignment device can provide a proper alignment between the power semiconductor device and another component, like a heat sink or a cooling device. Alternatively, the mounting of the alignment device to the power semiconductor device comprises the inserting of the at least one terminal into the at least one first alignment structure. Alternatively, the step of inserting the at least one terminal into the at least one first alignment structure happens before the mounting step to facilitate the mounting of the alignment device to the power semiconductor device. The step of mounting the alignment device to the power semiconductor device also includes mounting of the semiconductor device to the alignment device.

Due to aligning the alignment device to the printed circuit board (PCB), the first portion of the at least one terminal of the power semiconductor device is also aligned to the corresponding contact hole of the printed circuit board (PCB).

In virtue of this aspect, a proper alignment of terminals, for example of press-fit terminals, soldered terminals or pin terminals, of the power semiconductor device with respect to contact holes of the printed circuit board (PCB), for instance of the control board, can be facilitated. Hence, it can be avoided that some terminals, for instance some auxiliary terminals, power terminals or control terminals of the power semiconductor device would be bent or displaced and thus would not fit into the contact holes of the printed circuit board (PCB). The fixation of the terminals to the printed circuit board (PCB) is done e.g**.** by soldering or by a press-fit contact at the end of the terminals. The terminals can feature crossbars for additional support of the terminals during insertion of the terminals into the PCB. Additionally, the alignment device provides mechanical support to the terminals when inserting them into the contact holes due to structures corresponding with the crossbars or additional structures.

Alternatively or additionally, the PCB and the power semiconductor device are mounted together with further mounting structures to improve mechanical stability and connection between the power semiconductor device and the printed circuit board.

The at least one terminal is inserted in a slot of the alignment device, such that a first portion of the at least one terminal is oriented in the same direction as the slot, and limiting the movement of the at least one terminal in a first direction and/or in a second direction. Even if the terminal is tilted or in an unusual position. The slot receives the at least one terminal and orients the first and second portions of the terminal in a predetermined angle to be properly aligned to the printed circuit board (PCB) for further mounting. Thus, the first portion and the second portion of the terminal are at a predetermined angle before the power semiconductor device is mounted to the printed circuit board (PCB). The movement of the terminal is be limited in the first and in the second direction.

Mounting of the alignment device to the power semiconductor device occurs in a simple manner. The power semiconductor device is just moved in the third direction towards the alignment device. Alternatively or additionally the alignment device is moved in the opposing direction of the third direction towards the semiconductor power device. Inserting the at least one terminal into the alignment device limits the movement of the at least one terminal in the third direction by a rear wall of the first alignment structure, like the slot. Even if the terminal was not proper positioned with respect to the third direction, the rear wall will provide support and if necessary bend the terminal back to a predetermined position and/or angle for further mounting.

After mounting of the alignment device and the power semiconductor device, the at least one terminal is well supported by the alignment device. The insertion of the first portion of the at least one terminal comprises moving the power semiconductor device in a fourth direction. The power semiconductor device can be just moved in the fourth direction towards the printed circuit board (PCB) without further aligning the power semiconductor device. Alternatively or additionally the power semiconductor device is moved together with the alignment device in the fourth direction towards the printed circuit board. Alternatively, or additionally the printed circuit board is moved in a fifth direction towards the power semiconductor device and/or the alignment device. The alignment device already provides a simple aligning of the at least one terminal with respect to the printed circuit board (PCB), especially to the corresponding contact holes. This is a simple step to mount or attach the power semiconductor device to the printed circuit board (PCB). It is not necessary to be overcautious to prevent bending of the at least one terminal of the power semiconductor device.

While inserting the first portion of the at least one terminal the movement of the at least one terminal is limited in the fifth direction, which points in the opposite direction of the fourth direction. An optional bottom surface of the slot may provide the support for the terminal while inserting the terminal into the corresponding contact hole of the printed circuit board (PCB). The bottom surface limits the movement of the terminal in the fifth direction and thus prevents unwanted bending of the terminal, especially in the fifth direction. Alternatively, or additionally support can be provided by a top surface of the sidewalls if terminals with crossbars, like press-fit terminals, are used for connecting the power semiconductor device to the printed circuit board (PCB). In case of a terminal with a crossbar, the support of the terminal can be provided by only the top surface of the sidewalls without the necessity of a bottom surface. Additionally, depressions on the top surface can further improve the support of the terminal in the fifth direction and/or also in the third direction, if crossbars are available. The depressions on the top surface can also provide further alignment in the third direction, especially if the first portion of the terminal is bent towards the power semiconductor device.

The alignment device is mounted to the power semiconductor device by fixing at least one second mounting structure of the alignment device to a corresponding at least one first mounting structure of the power semiconductor device. The mounting structures simplify the mounting step and fix the devices together. The mounting structures are integral parts of the alignment device and the power semiconductor device, which provide a positioning and fixation of the alignment device on corresponding structures on the power semiconductor device. Alternatively or additionally, the mounting structures of the alignment device and the power semiconductor device can be different parts, which are fixedly or temporarily available on the alignment device and/or on the power semiconductor device.

The mounting of the alignment device to the printed circuit board is optional. In this case, the alignment device is mounted to the printed circuit board (PCB), for example by fixing at least one third mounting structure of the alignment device to at least one fourth mounting structure of the printed circuit board (PCB). The fixing is not only done by the terminals of the power semiconductor device and the contact holes, but can also be realized by separate and/or integral mounting structures to improve the mounting. This avoids tear-off of the terminals. The term fixing refers to mechanical fixing and/or electrically contacting for example the terminal and the printed circuit board.

Depending on the used terminal fixation and used mounting structure, mounting of the alignment device to the printed circuit board is concurrent with inserting at least partially the first portion of the at least one terminal. For instance, if the at least one terminal is fixed to the printed circuit board via soldering, the mounting can happen before fixing the terminals to the PCB to secure the power semiconductor device and the printed circuit board avoiding a tear-off of the at least one terminal. Before fixing the terminals to the PCB refers, for example, to mounting the alignment device at the same time as inserting the at least one terminal.

Alternatively, the mounting of the alignment device to the printed circuit board happens after inserting at least partially the first portion of the at least one terminal. For instance, by using press-fit terminals, first the insertion happens then the mounting and then the fixing of the terminals to the PCB. In this case the mounting structures are for example a screw and a screw hole. Alternatively mounting happens after fixing the at least one terminal to the PCB to secure the whole setup.

Additionally, the alignment device can also be mounted to another component, like a heat sink or a cooling device by fixing at least one fifth mounting structure of the alignment device to at least one sixth mounting structure of the another component. The third and fifth mounting structure may be the same part, for example, if another component, like a cooling device and the printed circuit board (PCB) are commonly joined by a long common screw or bolt. The another component can be a cooling device or a heat sink, which is attached below the semiconductor device in case the printed circuit board (PCB) is attached above the power semiconductor device. In general the another component, like a cooling device is typically attached to a side of the power semiconductor device, which is opposite to the side of the power semiconductor device to which the printed circuit board is attached. The alignment device can be fixed to the power semiconductor device only, but also to corresponding mounting structures of another component, like a cooler or a heatsink, which would provide improved mechanical support. The mounting structures and their counterparts are for example clamps and shoulders and/or screws and threads and/or glue and other adhesives. A combination of the listed mounting structures is also possible. The different mounting structures are not limited to a specific type of a mounting structure. For example, a combination of clamps and shoulders, and screws and threads is possible.

There is also provided a power semiconductor device. The power semiconductor device comprises a side surface and at least one terminal located at the side surface of the power semiconductor device. The at least one terminal comprises a first portion oriented in a fourth direction and a second portion oriented in a third direction. The third direction is perpendicular to the fourth direction. The terminals can be press-fit terminals. For example, the press-fit terminals have press-fit connectors on their end portions. In addition or as an alternative, the press-fit terminal may comprise a crossbar for providing mechanical support when inserting the press-fit terminal into the contact hole. Alternatively the terminals are pin terminals. The pin terminals can be soldered to the printed circuit board. The pin terminals can also comprise crossbars. Thus, the mechanical support is provided by the alignment device when there are mechanical supports, like depressions on top of the sidewalls of the slot for the crossbars. The power semiconductor device further comprises at least one first mounting structure, adapted for attaching the power semiconductor device to a corresponding at least one second mounting structure of an alignment device. The mounting structures and their counterparts are for example clamps and shoulders and/or screws and threads and/or glue and other adhesives. A combination of the listed mounting structures is also possible. The different mounting structures are not limited to a specific type of a mounting structure. For example, a combination of clamps and shoulders, and screws and threads is possible. The power semiconductor device may be fixedly connected e.g. by gluing, permanent clamping or permanent screwing. On the other hand, the fixation by clamping or screwing may facilitate a temporary arrangement of the power semiconductor device.

The power semiconductor device can be any device, which needs proper alignment of its terminals to printed circuit board. The power semiconductor device comprises for example an electronic chip, a semiconductor chip, an embedded semiconductor chip, a substrate with one or several chips arranged thereon, a diode, a component comprising silicone and/or silicon carbide and/or gallium nitride, circuit devices, discrete devices like a resistor, a capacitor, an inductive component and/or a transistor or switching device like IGBT, HEMT, MOSFET etc., but is not limited thereto.

The power semiconductor device can also be, for example, a large molded power package having auxiliary terminals, power terminals and/or control terminals on at least one side surface. Nevertheless, the alignment device may also apply to other types of power semiconductor devices and/or arrangements of auxiliary terminals, power terminals and/or control terminals. The terminals can be realized as pin terminals, but also as press-fit terminals. The terminals comprise the second portion adhering to the power semiconductor device and the first portion for external interconnection. The terminals are made of, for example copper or corresponding copper alloy. Other electrically conductive materials are considerable.

There is also provided an alignment device. The alignment device comprises a second side surface extending in a first direction and in a second direction, a third side surface extending in the first direction and in the second direction and at least one second mounting structure, adapted for attaching the alignment device to the corresponding at least one first mounting structure of the power semiconductor device.

The alignment device further comprises at least one first alignment structure adapted for receiving a terminal of the power semiconductor device and comprises at least one sidewall protruding from the second side surface in a direction opposite to the third direction and extending in a fourth direction. The third direction is perpendicular to the fourth direction, the fourth direction is perpendicular to the first direction and the third direction is perpendicular to the first direction. The alignment structure further comprises a rear wall, which is provided by at least a part of the second side surface, enclosing with at least two of the sidewalls a space and forming at least one slot oriented in the fourth direction and in the third direction.

The alignment device further comprises a bottom surface extending in the first direction and in the second direction and protrudes from the second side surface and/or from the third side surface in the third direction. In this case the at least one sidewall extends in the third direction and protrudes from the bottom surface in the fourth direction. The alignment in the first direction and/or in the second direction is provided by the at least one sidewall of the at least one slot, whereas the bottom surface of the slot is used optionally for the alignment in the fifth direction and for mechanical support when inserting the at least one terminal, for example a press-fit terminal without crossbars, to the corresponding contact hole. Alternatively, the at least one terminal comprises crossbars, such that top surfaces of the at least one sidewall support the at least one terminal in the fifth direction. Alternatively or additionally depressions on the top surface of the sidewall for the crossbars are available. These depressions may also support the alignment in the fifth direction and/or in the third direction. This provides an improved alignment in the third direction, especially, if the terminal is bent towards the power semiconductor device. A support in the third direction is also provided by the rear wall of the alignment device. By limiting the movement of the terminal in the different directions, unwanted bending of the terminal is prevented and a counterforce needed for the insertion of the terminal into the contact hole is provided, especially when inserting press-fit terminals into the contact holes.

The alignment device can be easily mounted to the peripheral region of the power semiconductor device, where the at least one terminal is located. On one hand, the alignment device may be fixedly connected e.g. by gluing, permanent clamping or permanent screwing. On the other hand, the fixation by clamping or screwing may facilitate a temporary arrangement of the alignment device. Here e.g. clamps, which are used for mounting and fixation of the alignment device, are fitting to corresponding mounting structures of the power semiconductor device.

The mounting structures are integral parts of the alignment device, which provide a positioning and fixation of the alignment device on corresponding structures on the power semiconductor device. Alternatively, mounting structures of the alignment device and/or of the power semiconductor device can be different parts, which are fixedly or temporarily available on the alignment device and/or on the power semiconductor device.

The alignment device also works for power terminals, which have a different design than pin or press-fit terminals, like a sheet, etc. Additionally or alternatively, the alignment device may have openings or other alignment structures for the insertion of power terminals, which may also be used as aligning and/or mounting structures. This further improves mounting and alignment between alignment device and power semiconductor device. The use of alignment structures for power terminals may support alignment and mounting between the alignment device and the power semiconductor device.

The alignment device can be made of any electrically isolating material, especially thermoplastic or thermosetting resin material, which is filled by particles or fibers of inorganic material. The manufacturing of the alignment device may be done by transfer molding, injection molding, or other applicable molding processes.

The alignment device can be attached to only one power semiconductor device. Alternatively, the alignment device can also be realized as a common device for multiple power semiconductor devices e.g. several equal power modules being arranged in a row on a cooler or heat sink forming a sixpack power module. Here the alignment device can be fixed to the power modules only, but also to corresponding mounting structures of a cooler or heatsink, which would provide improved mechanical support. In this case, the several power semiconductor devices may have a common printed circuit board, which is mounted and aligned with the commonly used alignment device.

In addition to the described alignment structure for the terminals, for example press-fit terminals, the alignment device may incorporate further features for the correct alignment between pin terminals or press-fit terminals and the printed circuit board (PCB), where the control terminals are inserted into holes. On one hand, there may be pins, which are inserted into corresponding holes or recesses of the printed circuit board (PCB) for a correct alignment between the control terminals and the printed circuit board (PCB) in lateral direction, in the first direction, second direction and/or third direction or a combination of these directions. The pins may have, for example a simple round shape, a square shape or a polygonal shape or a more complicated shape with a cross-like profile, which also may provide an alignment in the fourth direction and/or in the fifth direction. On the other hand, there may be bedstops, where the printed circuit board (PCB) is located on them to provide a correct vertical position of the printed circuit board (PCB) in the fourth direction. Additionally, the alignment device may have mounting holes for a fixation between the alignment device and the printed circuit board (PCB) and/or a fixation between the alignment device and another component, like a heat sink or a cooler.

The present disclosure comprises several aspects of a method for mounting a power semiconductor device to a printed circuit board (PCB), the power semiconductor device and an alignment device used for mounting the power semiconductor device. Every feature described with respect to one of the aspects is also disclosed herein with respect to the other aspect, even if the respective feature is not explicitly mentioned in the context of the specific aspect. For example, the method described in this disclosure is directed to a method for mounting the power semiconductor device using the alignment device described here. Thus, features and advantages described in connection with the power semiconductor device or the alignment device can be used for the method, and vice versa.

While the disclosure is amenable to various modifications and alternative forms, specifics thereof are shown by way of example in the figures and will be described in detail. The scope of the invention is defined by the appended claims.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figure 1 shows a perspective view of a power semiconductor device and an alignment device according to an embodiment,
Figure 2 shows a top view of a power semiconductor device and an alignment device according to an embodiment,
Figure 3 shows a side view of a power semiconductor device and an alignment device according to an embodiment,
Figure 4 shows a different side view of a power semiconductor device and an alignment device according to an embodiment,
Figure 5 shows method steps according to an example of a method for mounting a power semiconductor device.

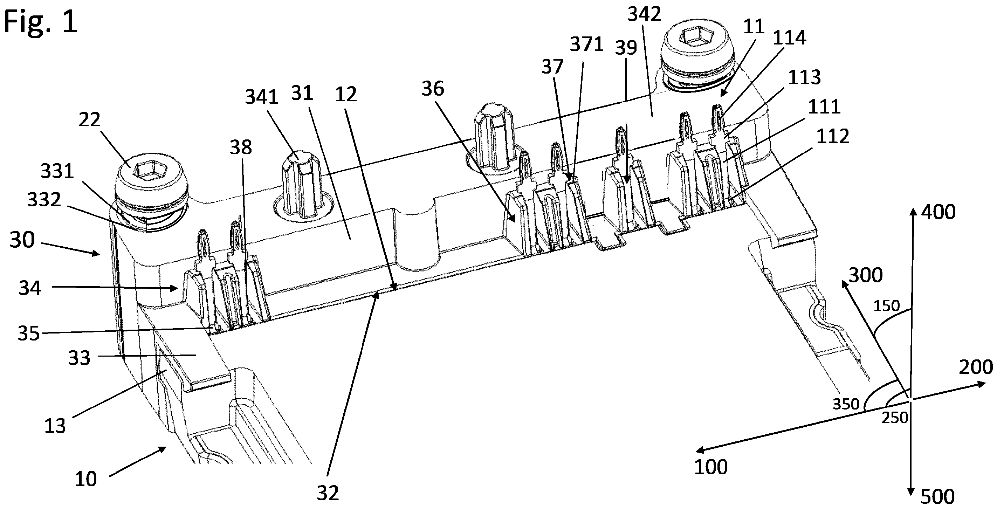

Figure 1 shows a perspective view of an alignment device 30 mounted to a power semiconductor device 10. The power semiconductor device 10 comprises a package body with a first side surface 12 extending in a first direction 100 and in an opposing second direction 200. At least one terminal 11 is located at the first side surface 12. The terminal 11 can be any of a pin terminal or a press-fit terminal. The terminal can comprise crossbars and/or press-fit contacts. The alignment device 30 comprises a second side surface 31 and a third side surface 32. In a mounted position the third side surface 32 of the alignment device 30 abuts on the first side surface 12 of the power semiconductor device 10.

In figure 1 the at least one terminal 11 is a press-fit terminal. The at least one terminal 11 comprises a first portion 111 and a second portion 112. In case of a press-fit terminal, the first portion 111 features a crossbar 113 and an end portion 114. The crossbar 113 is optional and provides mechanical support on the alignment device 30 when inserting the terminal 11, realized as press-fit part into a contact hole 21 of a printed circuit board 20 (not shown in figure 1). The at least one terminal 11 is alternatively a pin terminal without a crossbar 113. The first portion 111 extends along the fourth direction 400. The second portion extends along a third direction 300. The third direction 300 is in a predetermined first angle 150 to the fourth direction 400. The first angle 150 is a right angle. The crossbar 113 extends along a first direction 100 and second direction 200. The terminal 11 has a press-fit connector at the end portion 114.

The alignment device 30 furthermore comprises at least one first alignment structure 34 adapted for receiving the terminal 11 of the power semiconductor device 10. In figure 1 the alignment structure 34 comprises a bottom surface 35 extending in the first direction 100 and in the second direction 200. The bottom surface 35 is optional. At least one sidewall 36 protrudes from the bottom surface 35 in the fourth direction 400. The fourth direction 400 is in a predetermined second angle 250 to the first direction 100. The at least one sidewall 36 extends in a third direction 300. The third direction 300 is in a predetermined third angle 350 to the first direction 100. The second angle 250 and the third angle 350 are each a right angle. The alignment structure 34 furthermore comprises a rear wall 38, which is provided by at least a part of the second side surface 32. In Figure 1 the bottom surface 35, the rear wall 38 and at least two of the sidewalls 36 enclose a space and form at least one slot 39. Alternatively just the two sidewalls 36 and the rear wall 38 enclose a space to form the at least one slot 39 if no bottom surface 35 is present. In this case, the at least one 36 sidewall protrudes from the second side surface 31 in a direction opposite to the third direction 300 and extends in the fourth direction 400. The slot 39 is oriented in the fourth direction 400 and in the third direction 300 and receives the terminal 11. The rear wall 38 limits the movement of the at least one terminal in the third direction 300. The sidewalls 36 of the slot 39 limit the movement of the terminal 11 in the first direction 100 and/or in the second direction 200. Each sidewall 36 has a top surface 37. The top surface 37 can comprise one or more depressions 371. In case of using press-fit terminals, the crossbars 113 can rest on the top surface 37 of the sidewalls 36 or in the depressions 371. The depression 371 supports the insertion of the terminals 11 into the printed circuit board 20 (not shown in figure 1), when the printed circuit board 20 is moved in a fifth direction 500 towards the power semiconductor device 10, which points to the opposite direction of the fourth direction 400. Alternatively or additionally the power semiconductor device 10 is moved together with the alignment device 30 in the fourth direction 400 towards the printed circuit board 20. The top surface 37 of the sidewall 36 and optionally also the bottom surface 35 limit the movement of the terminal 11 in the fifth direction 500, when the movement of the printed circuit board 20 exerts a force on the terminals 11 in the fifth direction 500.

The alignment device 30 furthermore comprises at least one second mounting structure 33, adapted for attaching the alignment device 30 to a corresponding at least one first mounting structure 13 of the power semiconductor device 10. In this embodiment the second mounting structure 33 is a clamp, which is fixed to the corresponding first mounting structure 13, which is a shoulder. Alternatively, the second mounting structure 33 and the first mounting structure 13 are fastened in the opposite way. Then, the second mounting structure 33 is a shoulder and the first mounting structure 13 is a clamp. Alternative mounting structures and their counterparts are screws and threads and/or glue and other adhesives.

The alignment device 30 further comprises at least one third mounting structure 331 and at least one fifth mounting structure 332. The third mounting structure 331 can be attached to a corresponding at least one fourth mounting structure 22 of the printed circuit board 20 (not shown in figure 1). The fifth mounting structure 332 can be attached to a corresponding sixth mounting structure 41 (not shown in figure 1) of another component, like a heat sink or cooling device.

The listed mounting structures and their corresponding counterparts are as interchangeable as the first mounting structure 13 and the second mounting structure 33. Possible mounting structures and their counterparts are screws and threads and/or glue and other adhesives.

For the alignment of the alignment device 30 to the printed circuit board 20 (not shown in figure 1) at least one second alignment 341 structure and/or at least one third alignment structure 342 of the alignment device 30 together with at least one fourth alignment structure 23 of the printed circuit board (not shown in figure 1) are used. The alignment structures can be pins, bedstops or different protrusions and corresponding thereto holes, crevices, depressions or different recesses. The alignment structures can be any type of key lock mechanism.

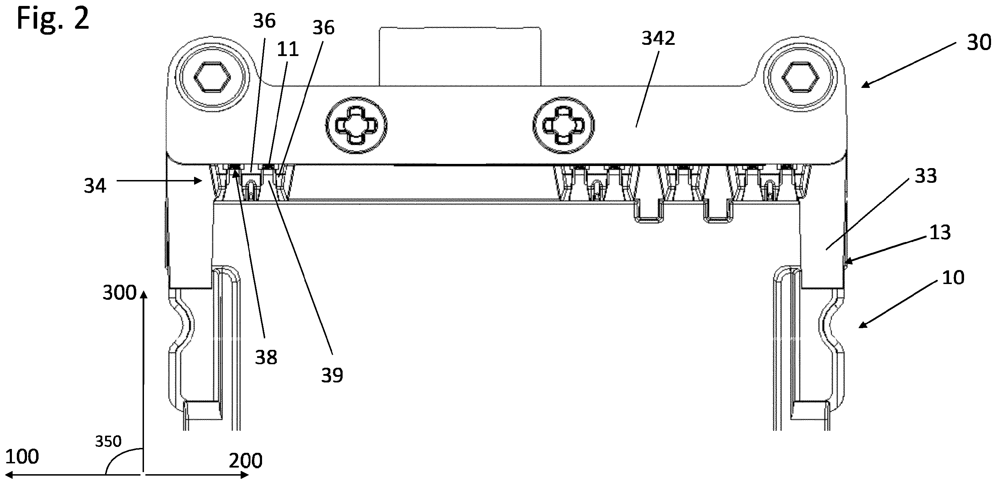

Figure 2 shows a top view of the alignment device 30 mounted to the power semiconductor device 10.

The alignment device 30 is mounted to the first mounting structures 13 of the power semiconductor device 10 via two second mounting structures 33. In this embodiment two clamps are used as second mounting structures 33. The corresponding first mounting structures 13 are two shoulders.

Two of the sidewalls 36 limit the movement of the at least one terminal 11 of the power semiconductor device 10 in the first direction 100 and in the second direction 200. Thus, a stable arrangement of the terminal 11 inside the first alignment structure 34, which is designed as slot 39, is provided. Furthermore the rear wall 38 limits the movement of the terminal 11 in the third direction 300 and supports the terminal 11 during a mounting process. Additionally, the top surfaces 37 of the sidewalls 36 used for locating of the crossbars 113 are used for support in the fourth direction 400.

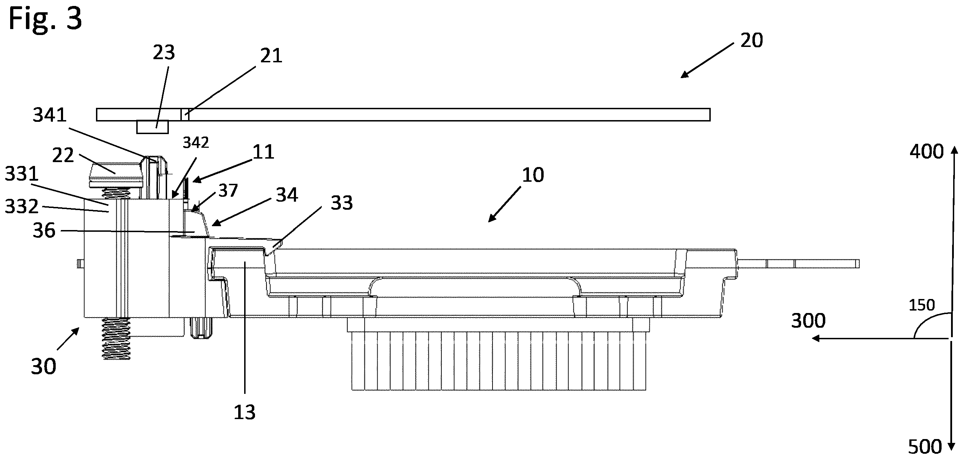

Figure 3 shows a side view of the alignment device 30 mounted to the power semiconductor device 10 and the printed circuit board 20, which is not yet mounted. The at least one second mounting structure 33 of the alignment device 30 is attached to the at least one first mounting structure 13 of the power semiconductor device 10. When the power semiconductor device 10 is moved in the fourth direction 400 or if the printed circuit board 20 is moved in the fifth direction 500 towards the power semiconductor device 10, the at least one terminal 11 is inserted in the corresponding at least one contact hole 21 of the printed circuit board 20. During insertion, the terminal 11 is supported by the at least one sidewall 36. Furthermore the alignment structure 34 provides mechanical support in the fifth direction 500 when inserting the terminal 11 into the contact hole 21 during movement of the power semiconductor device 10 in the fourth direction 400. In case of a press-fit terminal, the terminal 11 is also supported in the fifth direction 500 by the top surface 37 of the at least one sidewall 36.

The alignment device 30 further comprises at least one third mounting structure 331 to attach to the corresponding at least one fourth mounting structure 22 of the printed circuit board 20. The alignment device 30 further comprises at least one fifth mounting structure 332 to attach to the corresponding at least one sixth mounting structure 41 of another component, like a cooling device. In figure 3 the third mounting structure 331 and the fifth mounting structure 332 may form a common mounting structure, like a screw hole for a common fixation screw.

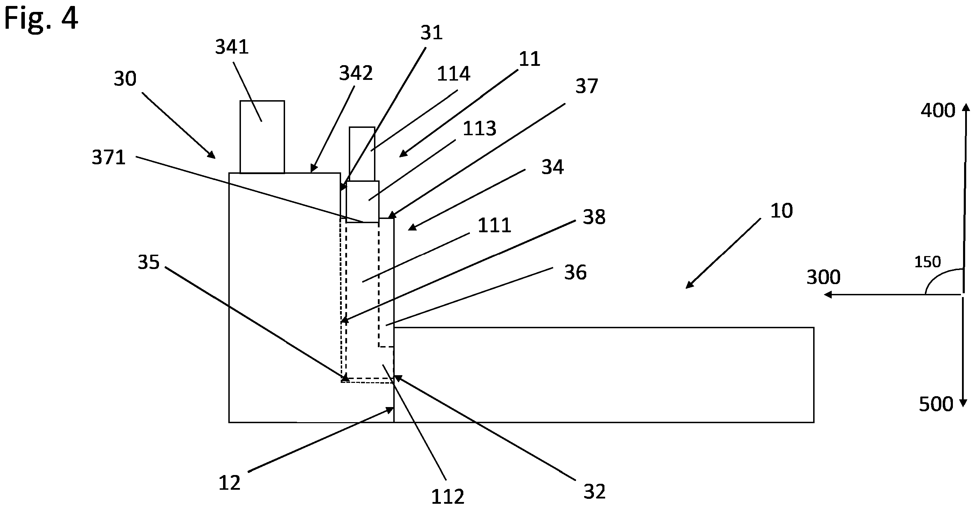

Figure 4 shows a different schematic side view of the alignment device 30 mounted to the power semiconductor device 10. The third side surface 32 of the alignment device 30 abuts on the first side surface 12 of the power semiconductor device 10. The terminal 11 is located on the first side surface 12. The first portion 111 of the terminal 11 is oriented in the fourth direction 400 and the second portion 112 of the terminal 11 is oriented in the third direction 300 protruding from the second side surface 12. The third direction 300 is in the predetermined first angle 150 to the fourth direction 400. The first angle 150 is a right angle. The first portion 111 of the terminal 11 is supported in the third direction 300 by the part of the second side surface 31, which forms the rear wall 38. The first portion 111 does not necessary touch the rear wall 38. There can still be a gap between the first portion 111 and the rear wall 38. The rear wall 38 limits the movement of the terminal 11 and still provides enough support for the terminal 11 during the mounting procedure to prevent an unwanted bending or even breaking of the terminal 11. The second portion 112 of the terminal 11 is supported in the fifth direction 500 by the bottom surface 35. The second portion 112 does not necessary touch the bottom surface 35. There can still be a gap between the second portion 112 and the bottom surface 35. The bottom surface 35 limits the movement of the terminal 11 and still provides enough support for the terminal 11 during the mounting procedure to prevent an unwanted bending or even breaking of the terminal 11. Alternatively or additionally the crossbar 113, for example of a press-fit terminal, rests on the top surface 37 of the sidewall 36 for further support. In this case the alignment device 30 has no bottom surface 35. To further improve the mechanical support in the fifth direction 500 and/or in the third direction 300 and the alignment in the third direction 300, the crossbar 113 rests in the depression 371 on the top surface 37. The second alignment structure 341 and/or the third alignment structure 342 afford the alignment of the alignment device 30 with respect to the printed circuit board 20 (not shown in figure 4). For fixing the terminal 11 to the printed circuit board 20 (not shown in figure 4) the end portion 114 is used. The end portion is for example a press-fit contact of a press-fit terminal.

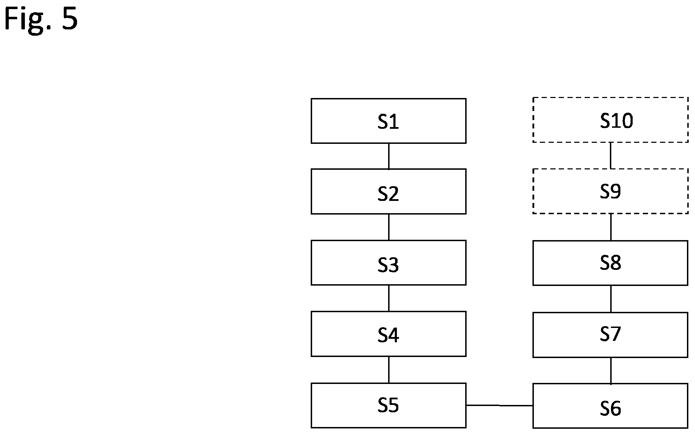

Figure 5 shows the steps of a method to mount the power semiconductor device 10 to the printed circuit board 20. In a first step S1 the power semiconductor device 10 is provided. In a second step S2 the alignment device 30 is provided. In a third step S3 the power semiconductor device 10 is moved in the third direction 300 towards the alignment device 30, such that at least one terminal 11 of the power semiconductor device 10 is inserted into the at least one first alignment structure 34 of the alignment device 30. Alternatively or additionally the alignment device 30 is moved in the opposing direction of the third direction 300 towards the semiconductor power device 10. The alignment structure 34 is for example a slot 39, which receives the terminal 11. Both, the slot 39 and the first portion 111 of the terminal 11 are oriented in the same direction. For example, in the fourth direction 400 and/or in the third direction 300. The slot 39 provides the at least one sidewall 36, which limit/s the movement of the terminal 11 in the first direction 100 and/or in the second direction 200. Furthermore the movement of the terminal 11 is limited in the third direction 300 by the rear wall 38. The top surface 37 of the sidewalls 36 limits the movement of the press-fit terminal in the fifth direction 500, if the terminal 11 comprises crossbars 113, which rest on the top surface 37. In addition the movement of the terminal 11 can be limited in the fifth direction 500 for example by the bottom surface 35. The terminal 11 is for example a press-fit terminal or a pin terminal. In a fourth step S4 the alignment device 30 is mounted to the power semiconductor device 10 by fixing the at least one second mounting structure 33 of the alignment device 30 to the corresponding at least one first mounting structure 13 of the power semiconductor device 10, for example by snapping of the clamp to the shoulder or by gluing. Depending on the mounting method, the third step S3 and the fourth step S4 may be simultaneous. The mounting structures and their counterparts are for example, clamps and shoulders and/or screws and threads. Glue and/or other adhesives are used for joining of the mounting structures and their counterparts. A combination of the listed mounting structures is also possible. They can be used in pairs or in a different amount to provide secure attachment of the aligning device 30 to the semiconductor device 10. For example the first mounting structure is a shoulder and the second mounting structure comprises two clamps. In a fifth step S5 the printed circuit board 20 is provided. In a sixth step S6 the alignment device 30 is aligned with respect to the printed circuit board 20. For the alignment, the at least one second alignment 341 structure and/or the at least one third alignment structure 342 of the alignment device 30 together with the at least one fourth alignment structure 23 or other corresponding alignment structures are used. The alignment structures 34 can be pins, bedstops or different protrusions and corresponding thereto holes, crevices or different recesses. The alignment structures 34 can be any type of key lock mechanism. In a seventh step S7 the first portion 111 of the at least one terminal 11 is inserted into the at least one contact hole 21 of the printed circuit board 20. For this purpose the power semiconductor device 10 is moved in the fourth direction 400 towards the printed circuit board 20. Alternatively or additionally the printed circuit board 20 is moved in the fifth direction 500 towards the semiconductor power device 10. By inserting the at least one terminal 11 in the at least one contact hole 21 a force acts in the opposite direction, which is the fifth direction 500, to the direction of the movement, which is the fourth direction 400. The force acts on the first portion 111 and the second portion 112 of the terminal 11 and consequently on the slot 39, on the top surface 37 of its sidewalls 36 and/or the bottom surface 34, which support the terminal 11 and prevent unwanted bending of the first portions 111 and second portions 112, when the first portions 111 are inserted into the contact holes 21 of the printed circuit board 20. The sixth step S6 and the seventh step S7 may be simultaneous. In an eighth step S8 the first portion 111 of the at least one terminal 11 is fixed to the printed circuit board 20. Fixing is done for example by soldering or by a press-fit contact. After fixing the at least one terminal 11 to the printed circuit board 20, the alignment device 30 can stay attached to the power semiconductor device 10. In an optional ninth step S9 the alignment device 30 is mounted to the printed circuit board 20. In this case the at least one third mounting structure 331 of the alignment device 30 is fixed to the at least one fourth mounting structure 22 of the printed circuit board 20. Depending on the used mounting structures the ninth step can happen after the eight step S8 of fixing the at least one terminal 11 to the printed circuit board 20 to secure the whole structure. For instance, if screws and screw holes are used as mounting structures. Alternatively, the ninth step S9 is executed simultaneously with the seventh step S7 of inserting the first portion 111 of the at least one terminal 11 into the at least one contact hole 21 of the printed circuit board 20. This is the case, for instance, by using press-fit terminals as terminal 11 and shoulder and clamp as mounting structures. Alternatively, Step S9 of mounting the alignment device 30 to the printed circuit board 20 happens before Step S8 and after step S7. In this case the fixing of the first portion 111 of the at least one terminal 11 to the printed circuit board 20 is done by soldering. To avoid a possible tear-off, the alignment device 30 and the printed circuit board 20 are mounted together. In an optional tenth step S10 the at least one fifth mounting structure 332 of the alignment device 30 is fixed to the at least one sixth mounting structure 41 of another component, for example a cooler or a heat sink. The tenth step S10 can be executed before step S5 or in between steps S5 to S9.

After mounting the power semiconductor device 10 to the printed circuit board 20 it is possible to remove the alignment device 30 if it is not permanently fixed to the cooling device and/or fixedly connected with the printed circuit board 20 and/or with the power semiconductor device 10 or to another component.

The embodiments shown in the Figures as stated represent exemplary embodiments of the power semiconductor device and of the alignment device for mounting the power semiconductor device; therefore, they do not constitute a complete list of all embodiments according to the improved arrangement for the power semiconductor device or the alignment device. Actual arrangements of the power semiconductor device or of the alignment device may vary from the exemplary embodiments described above.

### Reference signs

- 10: power semiconductor device
- 11: terminal
- 111: first portion
- 112: second portion
- 113: crossbar
- 114: head portion
- 12: first side surface
- 13: first mounting structure

- 20: printed circuit board
- 21: contact hole
- 22: fourth mounting structure
- 23: fourth alignment structure

- 30: alignment device
- 31: second side surface
- 32: third side surface
- 33: second mounting structure
- 331: third mounting structure
- 332: fifth mounting structure
- 34: first alignment structure
- 341: second alignment structure
- 342: third alignment structure
- 35: bottom surface
- 36: sidewall
- 37: top surface
- 371: depression
- 38: rear wall
- 39: slot

- 41: sixth mounting structure
- 100: first direction
- 150: predetermined first angle
- 200: second direction
- 250: predetermined second angle
- 300: third direction
- 350: predetermined third angle
- 400: fourth direction
- 500: fifth direction

## Claims

1. Arrangement comprising an alignment device (30) and a power semiconductor device (10), wherein the semiconductor device (10) comprises a first side surface (12) and at least one terminal located at the first side surface (12), wherein the alignment device (30) is mounted to the power semiconductor device (10), comprising:
- a second side surface (31) extending in a first direction (100) and in a second direction (200),
- a third side surface (32) extending in the first direction (100) and in the second direction (200),
- at least one second mounting structure (33), adapted for attaching the alignment device (30) to a corresponding at least one first mounting structure (13) of the power semiconductor device (10),
- at least one first alignment structure (34) adapted for receiving a terminal (11) of the power semiconductor device (10) and comprising,
- at least two sidewalls (36) protruding from the second side surface (31) in a direction opposite to a third direction (300) and extending in a fourth direction (400),
- a rear wall (38), which is provided by at least a part of the second side surface (31), enclosing with at least two of the sidewalls (36) a space and forming at least one slot (39) oriented in the third direction (300) and in the fourth direction (400), wherein
- the slot (39) is configured to receive the terminal (11),
- the rear wall (38) limits a movement of the terminal (11) of the power semiconductor device (10) in the third direction (300),
- the two of the sidewalls (36) limit the movement of the terminal (11) of the power semiconductor device (10) in the first direction (100) and in the second direction (200),
- the second side surface (31) is offset from the third side surface (32) in the third direction (300), wherein the third direction (300) faces away from the power semiconductor device that is fixed to the alignment device,
- the first direction (100) and the second direction (200) are parallel to one another, and the third direction (300) is perpendicular to the first direction (100) and the second direction (200),
- the third side surface (32) of the alignment device (30) is configured to abut on the first side surface (12) of the power semiconductor device (10)
- the fourth direction (400) is perpendicular to the first direction (100), the second direction (200), and the third direction (300)
- the third side surface (32) in the first direction or the second direction extends up to one of the at least two sidewalls (36), and
- the second mounting structure (33) extends in a direction opposite to the third direction (300) beyond the second side surface (31) and the third side surface (32).

2. Arrangement according to claim 1, wherein the first alignment structure (34) comprises a bottom surface (35) extending in the first direction (100), in the second direction (200) and in the third direction (300), wherein the at least one sidewall (36) extends in the third direction (300) and protrudes from the bottom surface (35) in the fourth direction (400).

3. Arrangement according to claim 1 or 2, wherein the at least one sidewall (36) has a top surface (37) supporting a crossbar (113) of the at least one terminal (11) of the power semiconductor device (10).

4. Arrangement according to any one of the preceding claims, wherein the top surface (37) of the at least one sidewall (36) has a depression (371) to improve support and location of the crossbar (113) of the at least one terminal (11) of the power semiconductor device (10).

5. Method for mounting the alignment device (30) to the power semiconductor device (10) according to any of the claims 1 to 4, and mounting the power semiconductor device (10) to a printed circuit board (20) comprising
- providing the power semiconductor device (10),
- providing the alignment device (30),
- inserting the at least one terminal (11) with a first portion (111) oriented in the fourth direction (400) and a second portion oriented in the third direction (300), of the power semiconductor device (10) into the at least one first alignment structure (34) of the alignment device (30) by moving the power semiconductor device (10) in the third direction (300), concurrent with
- mounting the alignment device (30) to the power semiconductor device (10),
- providing the printed circuit board (20),
- aligning the printed circuit board (20) to the alignment device (30), concurrent with
- inserting at least partially the first portion (111) of the at least one terminal (11) into at least one contact hole (21) of the printed circuit board (20), wherein inserting the first portion (111) of the at least one terminal (11), comprises moving the power semiconductor device (10) with the alignment device (30) in the fourth direction (400), and
- fixing the first portion (111) of the at least one terminal (11) of the power semiconductor device (10) to the printed circuit board (20).

6. Method according to claim 5, wherein inserting the at least one terminal (11) comprises,
- receiving the at least one terminal (11) in the slot (39) of the alignment device (30), such that the first portion (111) of the at least one terminal (11) is oriented in the same direction as the slot (39) and
- limiting the movement of the at least one terminal (11) in the first direction (100) and/or in the second direction (200).

7. Method according to claim 5 or **6,** wherein inserting the at least one terminal (11) comprises, limiting the movement of the at least one terminal (11) in the third direction (300).

8. Method according to any one of the claims 5 to **7,** wherein inserting the first portion (111) of the at least one terminal (11), comprises limiting the movement of the at least one terminal (11) in a fifth direction (500), which points in the opposite direction of the fourth direction (400).

9. Method according to any one of the claims 5 to 8, wherein mounting of the alignment device (30) to the power semiconductor device (10) comprises, fixing the at least one second mounting structure (33) of the alignment device (30) to the corresponding at least one first mounting structure (13) of the power semiconductor device (10).

10. Method according to any one of the claims 5 to 8, comprising the step of mounting the alignment device (30) to the printed circuit board (20),
- concurrent with inserting at least partially the first portion (111) of the at least one terminal (11), or
- after inserting at least partially the first portion (111) of the at least one terminal (11).

11. Method according to claim 10, wherein mounting of the alignment device (30) to the printed circuit board (20) comprises, fixing at least one third mounting structure (331) of the alignment device (30) to at least one fourth mounting structure (22) of the printed circuit board (20).

12. Method according to any one of the claims 5 to 11, comprising the step of mounting the alignment device (30) to another component by fixing at least one fifth mounting structure (332) of the alignment device (30) to at least one sixth mounting structure (41) of another component.

## Patentansprüche

1. Anordnung, die eine Ausrichtungsvorrichtung (30) und eine Leistungshalbleitervorrichtung (10) umfasst, wobei die Halbleitervorrichtung (10) eine erste Seitenfläche (12) und mindestens einen Anschluss umfasst, der sich an der ersten Seitenfläche (12) befindet, wobei die Ausrichtungsvorrichtung (30) an die Leistungshalbleitervorrichtung (10) montiert ist, wobei die Anordnung Folgendes umfasst:
- eine zweite Seitenfläche (31), die sich in einer ersten Richtung (100) und in einer zweiten Richtung (200) erstreckt,
- eine dritte Seitenfläche (32), die sich in der ersten Richtung (100) und in der zweiten Richtung (200) erstreckt,
- mindestens eine zweite Montagestruktur (33), die dafür ausgelegt ist, die Ausrichtungsvorrichtung (30) an mindestens einer entsprechenden Montagestruktur (13) der Leistungshalbleitervorrichtung (10) zu befestigen,
- mindestens eine erste Ausrichtungsstruktur (34), die dafür ausgelegt ist, einen Anschluss (11) der Leistungshalbleitervorrichtung (10) aufzunehmen, und Folgendes umfasst:
- mindestens zwei Seitenwände (36), die von der zweiten Seitenfläche (31) in einer Richtung, die einer dritten Richtung (300) entgegengesetzt ist, vorstehen und sich in einer vierten Richtung (400) erstrecken,
- eine Rückwand (38), die durch zumindest einen Teil der zweiten Seitenfläche (31) bereitgestellt wird, die mit mindestens zwei der Seitenwände (36) einen Raum einschließt und mindestens einen Spalt (39) bildet, der auf die dritte Richtung (300) und auf die vierte Richtung (400) ausgerichtet ist, wobei
- der Spalt (39) konfiguriert ist, den Anschluss (11) aufzunehmen,
- die Rückwand (38) eine Bewegung des Anschlusses (11) der Leistungshalbleitervorrichtung (10) in der dritten Richtung (300) begrenzt,
- die zwei der Seitenwände (36) die Bewegung des Anschlusses (11) der Leistungshalbleitervorrichtung (10) in der ersten Richtung (100) und der zweiten Richtung (200) begrenzen,
- die zweite Seitenfläche (31) in der dritten Richtung (300) von der dritten Seitenfläche (32) versetzt ist, wobei die dritte Richtung (300) von der Leistungshalbleitervorrichtung, die an der Ausrichtungsvorrichtung fixiert ist, weg zeigt,
- die erste Richtung (100) und die zweite Richtung (200) parallel zueinander sind und die dritte Richtung (300) senkrecht zu der ersten Richtung (100) und der zweiten Richtung (200) ist,
- die dritte Seitenfläche (32) der Ausrichtungsvorrichtung (30) konfiguriert ist, an der ersten Seitenfläche (12) der Leistungshalbleitervorrichtung (10) anzuliegen,
- die vierte Richtung (400) senkrecht zu der ersten Richtung (100), der zweiten Richtung (200) und der dritten Richtung (300) ist,
- die dritte Seitenfläche (32) sich in der ersten Richtung oder der zweiten Richtung bis zu einer der mindestens zwei Seitenwände (36) erstreckt, und
- die zweite Montagestruktur (33) sich in einer Richtung, die der dritten Richtung (300) entgegengesetzt ist, über die zweite Seitenfläche (31) und die dritte Seitenfläche (32) hinaus erstreckt.

2. Anordnung nach Anspruch 1, wobei die erste Ausrichtungsstruktur (34) eine Bodenfläche (35) umfasst, die sich in der ersten Richtung (100), in der zweiten Richtung (200) und in der dritten Richtung (300) erstreckt, wobei sich die mindestens eine Seitenwand (36) in der dritten Richtung (300) erstreckt und von der Bodenfläche (35) in der vierten Richtung (400) vorsteht.

3. Anordnung nach Anspruch 1 oder 2, wobei die mindestens eine Seitenwand (36) eine obere Fläche (37) aufweist, die einen Querbalken (113) des mindestens einen Anschlusses (11) der Leistungshalbleitervorrichtung (10) trägt.

4. Anordnung nach einem der vorhergehenden Ansprüche, wobei die obere Oberfläche (37) der mindestens einen Seitenwand (36) eine Vertiefung (371) aufweist, um das Tragen und die Positionierung des Querbalkens (113) des mindestens einen Anschlusses (11) der Leistungshalbleitervorrichtung (10) zu verbessern.

5. Verfahren zum Montieren der Ausrichtungsvorrichtung (30) an die Leistungshalbleitervorrichtung (10) nach einem der Ansprüche 1 bis 4 und Montieren der Leistungshalbleitervorrichtung (10) auf einer gedruckten Leiterplatte (20), wobei das Verfahren Folgendes umfasst:
- Bereitstellen der Leistungshalbleitervorrichtung (10),
- Bereitstellen der Ausrichtungsvorrichtung (30),
- Einsetzen des mindestens einen Anschlusses (11), wovon ein erster Abschnitt (111) auf die vierte Richtung (400) ausgerichtet ist und ein zweiter Abschnitt auf die dritte Richtung (300) ausgerichtet ist, der Leistungshalbleitervorrichtung (10) in die mindestens eine erste Ausrichtungsstruktur (34) der Ausrichtungsvorrichtung (30) durch Bewegen der Leistungshalbleitervorrichtung (10) in der dritten Richtung (300), gleichzeitig mit
- Montieren der Ausrichtungsvorrichtung (30) an die Halbleitervorrichtung (10),
- Bereitstellen der gedruckten Leiterplatte (20),
- Ausrichten der gedruckten Leiterplatte (20) auf die Ausrichtungsvorrichtung (30), gleichzeitig mit
- zumindest teilweisem Einsetzen des ersten Abschnitts (111) des mindestens einen Anschlusses (11) in mindestens ein Kontaktloch (21) der gedruckten Leiterplatte (20), wobei das Einsetzen des ersten Abschnitts (111) des mindestens einen Anschlusses (11) das Bewegen der Leistungshalbleitervorrichtung (10) mit der Ausrichtungsvorrichtung (30) in der vierten Richtung (400) umfasst, und
- Fixieren des ersten Abschnitts (111) des mindestens einen Anschlusses (11) der Leistungshalbleitervorrichtung (10) an der gedruckten Leiterplatte (20).

6. Verfahren nach Anspruch 5, wobei das Einsetzen des mindestens einen Anschlusses (11) Folgendes umfasst:
- Aufnehmen des mindestens einen Anschlusses (11) in den Spalt (39) der Ausrichtungsvorrichtung (30) derart, dass der erste Abschnitt (111) des mindestens einen Anschlusses (11) auf dieselbe Richtung ausgerichtet ist wie der Spalt (39), und
- Begrenzen der Bewegung des mindestens einen Anschlusses (11) in der ersten Richtung (100) und/oder in der zweiten Richtung (200).

7. Verfahren nach Anspruch 5 oder 6, wobei das Einsetzen des mindestens einen Anschlusses (11) das Begrenzen der Bewegung des mindestens einen Anschlusses (11) in der dritten Richtung (300) umfasst.

8. Verfahren nach einem der Ansprüche 5 bis 7, wobei das Einsetzen des ersten Abschnitts (111) des mindestens Anschlusses (11) das Begrenzen der Bewegung des mindestens einen Anschlusses (11) in einer fünften Richtung (500), die in die Richtung zeigt, die der vierten Richtung (400) entgegengesetzt ist, umfasst.

9. Verfahren nach einem der Ansprüche 5 bis 8, wobei das Montieren der Ausrichtungsvorrichtung (30) an die Leistungshalbleitervorrichtung (10) das Fixieren der mindestens einen zweiten Montagestruktur (33) der Ausrichtungsvorrichtung (30) an der entsprechenden mindestens einen ersten Montagestruktur (13) der Leistungshalbleitervorrichtung (10) umfasst.

10. Verfahren nach einem der Ansprüche 5 bis 8, das den Schritt des Montierens der Ausrichtungsvorrichtung (30) auf der gedruckten Leiterplatte (20) umfasst,
- gleichzeitig mit dem zumindest teilweisen Einsetzen des ersten Abschnittes (111) des mindestens einen Anschlusses (11), oder
- nach dem zumindest teilweisen Einsetzen des ersten Abschnittes (111) des mindestens einen Anschlusses (11).

11. Verfahren nach Anspruch 10, wobei das Montieren der Ausrichtungsvorrichtung (30) auf der gedruckten Leiterplatte (20) das Fixieren mindestens einer dritten Montagestruktur (331) der Ausrichtungsvorrichtung (30) an mindestens einer vierten Montagestruktur (22) der gedruckten Leiterplatte (20) umfasst.

12. Verfahren nach einem der Ansprüche 5 bis 11, das den Schritt des Montierens der Ausrichtungsvorrichtung (30) an einer anderen Komponente durch Fixieren mindestens einer fünften Montagestruktur (332) der Ausrichtungsvorrichtung (30) an mindestens einer sechsten Montagestruktur (41) einer anderen Komponente umfasst.

## Revendications

1. Agencement comprenant un dispositif d'alignement (30) et un dispositif à semi-conducteur de puissance (10), le dispositif à semi-conducteur (10) comprend une première surface latérale (12) et au moins une borne située au niveau de la première surface latérale (12), le dispositif d'alignement (30) étant monté sur le dispositif à semi-conducteur de puissance (10), comprenant :
- une deuxième surface latérale (31) s'étendant dans une première direction (100) et dans une deuxième direction (200),
- une troisième surface latérale (32) s'étendant dans la première direction (100) et dans la deuxième direction (200),
- au moins une deuxième structure de montage (33), adaptée à fixer le dispositif d'alignement (30) à au moins une première structure de montage (13) correspondante du dispositif à semi-conducteur de puissance (10),
- au moins une première structure d'alignement (34) adaptée à recevoir une borne (11) du dispositif à semi-conducteur de puissance (10) et comprenant
- au moins deux parois latérales (36) faisant saillie à partir de la deuxième surface latérale (31) dans une direction opposée à une troisième direction (300) et s'étendant dans une quatrième direction (400),
- une paroi arrière (38), fournie par au moins une partie de la deuxième surface latérale (31), délimitant avec au moins deux des parois latérales (36) un espace et formant au moins une fente (39) orientée dans la troisième direction (300) et dans la quatrième direction (400),
- la fente (39) étant configurée pour recevoir la borne (11),
- la paroi arrière (38) limitant un mouvement de la borne (11) du dispositif à semi-conducteur de puissance (10) dans la troisième direction (300),
- les deux des parois latérales (36) limitant le mouvement de la borne (11) du dispositif à semi-conducteur de puissance (10) dans la première direction (100) et dans la deuxième direction (200),
- la deuxième surface latérale (31) étant décalée par rapport à la troisième surface latérale (32) dans la troisième direction (300), la troisième direction (300) étant orientée à l'opposé du dispositif à semi-conducteur de puissance qui est fixé au dispositif d'alignement,
- la première direction (100) et la deuxième direction (200) étant parallèles l'une à l'autre, et la troisième direction (300) étant perpendiculaire à la première direction (100) et à la deuxième direction (200),
- la troisième surface latérale (32) du dispositif d'alignement (30) étant configurée pour venir en appui sur la première surface latérale (12) du dispositif à semi-conducteur de puissance (10),
- la quatrième direction (400) étant perpendiculaire à la première direction (100), à la deuxième direction (200), et à la troisième direction (300),
- la troisième surface latérale (32) dans la première direction ou la deuxième direction s'étendant jusqu'à l'une des au moins deux parois latérales (36), et
- la deuxième structure de montage (33) s'étendant dans une direction opposée à la troisième direction (300) au-delà de la deuxième surface latérale (31) et de la troisième surface latérale (32).

2. Agencement selon la revendication 1, dans lequel la première structure d'alignement (34) comprend une surface inférieure (35) s'étendant dans la première direction (100), dans la deuxième direction (200) et dans la troisième direction (300), l'au moins une paroi latérale (36) s'étendant dans la troisième direction (300) et faisant saillie à partir de la surface inférieure (35) dans la quatrième direction (400).

3. Agencement selon la revendication 1 ou 2, dans lequel l'au moins une paroi latérale (36) présente une surface supérieure (37) supportant une barre transversale (113) de l'au moins une borne (11) du dispositif à semi-conducteur de puissance (10).

4. Agencement selon l'une quelconque des revendications précédentes, dans lequel la surface supérieure (37) de l'au moins une paroi latérale (36) présente un creux (371) destiné à améliorer le support et le positionnement de la barre transversale (113) de l'au moins une borne (11) du dispositif à semi-conducteur de puissance (10).

5. Procédé de montage du dispositif d'alignement (30) sur le dispositif à semi-conducteur de puissance (10) selon l'une quelconque des revendications 1 à 4, et de montage du dispositif à semi-conducteur de puissance (10) sur une carte de circuit imprimé (20), comprenant
- la fourniture du dispositif à semi-conducteur de puissance (10),
- la fourniture du dispositif d'alignement (30),
- l'insertion de l'au moins une borne (11), avec une première portion (111) orientée dans la quatrième direction (400) et une deuxième portion orientée dans la troisième direction (300), du dispositif à semi-conducteur de puissance (10) dans l'au moins une première structure d'alignement (34) du dispositif d'alignement (30) par déplacement du dispositif à semi-conducteur de puissance (10) dans la troisième direction (300), concomitamment avec
- le montage du dispositif d'alignement (30) sur le dispositif à semi-conducteur de puissance (10),
- la fourniture de la carte de circuit imprimé (20),
- l'alignement de la carte de circuit imprimé (20) avec le dispositif d'alignement (30), concomitamment avec
- l'insertion au moins partielle de la première portion (111) de l'au moins une borne (11) dans au moins un trou de contact (21) de la carte de circuit imprimé (20), l'insertion de la première portion (111) de l'au moins une borne (11) comprenant le déplacement du dispositif à semi-conducteur de puissance (10) avec le dispositif d'alignement (30) dans la quatrième direction (400), et
- la fixation de la première portion (111) de l'au moins une borne (11) du dispositif à semi-conducteur de puissance (10) à la carte de circuit imprimé (20).

6. Procédé selon la revendication 5, dans lequel l'insertion de l'au moins une borne (11) comprend
- la réception de l'au moins une borne (11) dans la fente (39) du dispositif d'alignement (30), de sorte que la première portion (111) de l'au moins une borne (11) soit orientée dans la même direction que la fente (39) et
- la limitation du mouvement de l'au moins une borne (11) dans la première direction (100) et/ou dans la deuxième direction (200).

7. Procédé selon la revendication 5 ou 6, dans lequel l'insertion de l'au moins une borne (11) comprend la limitation du mouvement de l'au moins une borne (11) dans la troisième direction (300).

8. Procédé selon l'une quelconque des revendications 5 à 7, dans lequel l'insertion de la première portion (111) de l'au moins une borne (11) comprend la limitation du mouvement de l'au moins une borne (11) dans une cinquième direction (500), orientée à l'opposé de la quatrième direction (400).

9. Procédé selon l'une quelconque des revendications 5 à 8, dans lequel le montage du dispositif d'alignement (30) sur le dispositif à semi-conducteur de puissance (10) comprend la fixation de l'au moins une deuxième structure de montage (33) du dispositif d'alignement (30) à l'au moins une première structure de montage (13) correspondante du dispositif à semi-conducteur de puissance (10).

10. Procédé selon l'une quelconque des revendications 5 à 8, comprenant l'étape de montage du dispositif d'alignement (30) sur la carte de circuit imprimé (20),
- concomitamment avec l'insertion au moins partielle de la première portion (111) de l'au moins une borne (11), ou
- après l'insertion au moins partielle de la première portion (111) de l'au moins une borne (11).

11. Procédé selon la revendication 10, dans lequel le montage du dispositif d'alignement (30) sur la carte de circuit imprimé (20) comprend la fixation d'au moins une troisième structure de montage (331) du dispositif d'alignement (30) sur au moins une quatrième structure de montage (22) de la carte de circuit imprimé (20).

12. Procédé selon l'une quelconque des revendications 5 à 11, comprenant l'étape de montage du dispositif d'alignement (30) sur un autre composant par fixation d'au moins une cinquième structure de montage (332) du dispositif d'alignement (30) sur au moins une sixième structure de montage (41) d'un autre composant.
